# EUROPEAN PATENT SPECIFICATION

(11) **EP 1 335 382 B1**
(45) Date of publication and mention of the grant of the patent: **27.09.2006**
(21) Application number: 03250581.0
(22) Date of filing: 30.01.2003
(51) Int. Cl.: G11C 11/16

(54) **Magnetic yoke structure in MRAM devices to reduce programming power consumption and a method to make the same**
Magnetisches Joch in MRAM zur Reduzierung des Programmierungsleistungsverbrauchs und Herstellungsverfahren
Culasse magnétique utilisée dans les MRAMs afin d'en réduire la puissance de consommation lors de la programmation et son procédé de fabrication

(30) Priority: 31.01.2002 US 61974
(43) Date of publication of application: 13.08.2003
(73) Proprietor: SHARP KABUSHIKI KAISHA, Osaka-shi, Osaka 545-8522 (JP)
(72) Inventor: Pan, Wei, Vancouver, WA 98683 (US); Hsu, Sheng Teng, Camas, WA 98607 (US)
(74) Representative: Brown, Kenneth Richard

(56) References cited:
- EP-A- 1 107 329
- EP-A- 1 296 332
- WO-A-00/72324
- WO-A-02/084755
- WO-A-03/019569
- US-A- 5 640 343
- US-B1- 6 211 090
- WANG Z G ET AL: "FEASIBILITY OF ULTRA-DENSE SPIN-TUNNELING RANDOM ACCESS MEMORY" IEEE TRANSACTIONS ON MAGNETICS, IEEE INC. NEW YORK, US, vol. 33, no. 6, November 1997 (1997-11), pages 4498-4512, XP000831059 ISSN: 0018-9464
- Y.SAITO: "Current status and advanced future technology in order to realize high-density" FED, [Online] 2001, XP002240920 Retrieved from the Internet: <URL:www.fed.or.jp/pub/review/FEDreviewV1N 25E1SaitoY.pdfwww.fed.or.jp/pub/review/FED reviewV1N25E1SaitoY.pdf> [retrieved on 2003-05-12]

## Description

### Field of the Invention

This invention relates to advanced non-volatile magnetic RAM (MRAM) devices, and specifically to a magnetic tunneling junction (MTJ) yoke structure for use in a MRAM device.

### Background of the Invention

Magnetic RAM has an advantage over convention RAM because of its non-volatility and fast data access. Of all the proposed MRAM structures, magnetic tunneling junction MRAM appears to be the first type of MRAM device to reach production. *Motorola aims to sample 4-Mbit MRAM in 2003, eetimes*, February 2001. A MTJ includes two ferromagnetic layers which are separated by an insulating tunnel barrier layer. The magnetoresistance (MR) effect is the result of spin-polarization tunneling of conductive electrons between the two ferromagnetic layers. The tunneling current is a factor of the relative orientation of magnetic moments in the two ferromagnetic layers. However, a significant disadvantage to the application of MRAM is the relatively large power consumption required during programming. The large power requirement is the result of the writing process, in which a programming current in the milli-ampere range is required in order to switch a free magnetic layer in the MRAM. Daughton, J.M., *Magnetic tunneling applied to memory*, J. Appl. Phys. 81(8) pp 3758-3763, April 1997. Data writing in MRAM devices is the result of the application of a magnetic field to a magnetic material, thereby magnetizing the material to one of two memory states. Reading is done by sensing a resistance charge in the magnetized material when a magnetic field is applied. Magnetic fields are created by a current passing through a line external to the magnetic material, as by passing a current through the magnetic material.

US Patent No. 5,640,343, to Gallagher *et al*., granted June 17, 1977, for *Magnetic memory array using magnetic tunnel junction devices in the memory cells,* provides general background information of MTJ devices, and explains how the devices are written to and read from.

US Patent No. 6,183,859, to *Chen et al.,* granted February 6, 2001, for *Low resistance MTJ*, describes methods for fabricating a low resistance magnetic RAM.

US Patent No. 6,304,477, to Nagi *et al*.*,* granted October 16, 2001, for *Content addressable magnetic random access memory*, describes an MRAM having differential tag program bit lines and a match line.

WO 00/72324 discloses a monolithically formed ferromagnetic thin-film memory that has local shielding on at least two sides of selected magnetic storage elements. The local shielding preferably extends along the back and side surfaces of a word line and/or digital lines of a conventional magnetic memory. In this configuration, the local shielding not only may help reduce externally generated EMI, internally generated cross-talk and other unwanted fields in the magnetic bit region, but may also help enhance the desired magnetic fields in the bit region.

EP 1 107 329 discloses a closed magnetic circuit layer which is formed on a ferromagnetic layer serving as a memory layer of a magnetic tunnel junction device, in such a manner that a closed magnetic circuit layer is formed via a metal layer with a spacing at a central portion. With this structure, stable magnetization state can be ensured even for a miniaturized pattern.

US 5,640,343 discloses a nonvolatile magnetic random access memory comprising an array of individual magnetic memory cells. Each memory cell is a magnetic tunnel junction element and a diode electrically connected in series. Each MTJ is formed of a pinned ferromagnetic layer whose magnetization direction is prevented from rotating, a free ferromagnetic layer whose magnetization direction is free to rotate between states of the parallel and antiparallel to the fixed magnetization of the pinned ferromagnetic layer, and an insulating tunnel barrier between and in contact with the two ferromagnetic layers. Each memory cell has a high resistance that is achieved in a very small surface area by controlling the thickness, and thus the electrical barrier height, of the tunnel barrier layer. The memory cells in the array are controlled by only two lines, and the write current to change the magnetic state of an MTJ, by use of the write currents' inherent magnetic fields to rotate the magnetization of the free layer, do not pass through the tunnel barrier layer. All MTJ elements, diodes, and contacts are vertically arranged at the intersection regions of the two lines and between the two lines to minimize the total MRAM surface area. The power expended to read or sense the memory cell's magnetic state is reduced by the height resistance of the MTJ and by directing the sensing current through a single memory cell.

WO 02/084755 discloses a magnetic memory device, such as a magnetic random access memory , and a method for forming same. The magnetic memory device includes a bit, such as a tunneling magneto-resistance structure or a giant magneto-resistance structure, which is sensitive to magnetic fields and stores data. The bit is preferably disposed between a top electrode with a magnetic keeper and a lower conducting line. The top electrode is formed by a damascene process and is preferably formed from copper. The magnetic keeper of the top electrode includes a magnetic material layer (eg. Co-Fe) and can also include a barrier layer (eg. Ta). This magnetic keeper comprises three discrete segments of magnetic material arranged in a horse shoe configuration. In addition, the magnetic keeper stack can be in contact with one, two, or three surfaces of the top electrode that face away from the bit.

EP 1 296 332 discloses a magnetic memory device that includes a data ferromagnetic layer having a magnetization that can be oriented in either of two directions, a reference layer and a spacer layer between the data and reference layer. The reference layer includes a dielectric layer, first and second conductors separated by the dielectric layer, and a ferromagnetic cladding on the first and second conductors.

The paper entitled *Current status and advanced future technology in order to realize high-density MRAM,* by Y. Saito discusses the current status of magnetic random access memory technology using magnetic tunnel junctions and reviews, involving materials, devices, and architectures and challenges in order to realize high-density TRAM based on the results of calculation and simulation. Recent developments of the materials and devices for MRAM are also described. MRAM using MTJ cells has a potential for high-density and high-speed nonvolatile memories. One transistor per one MTJ, a diode per MTJ cell and simple cross-point architecture would be feasible. The large bias dependence of MTJs and reductions of switching current and a switching field distribution are major technical challenges for MTJs. The former would be overcome by double tunnel junctions, and the latter may be overcome by an asymmetrical shape for the MTJ cell, antiferromagnetically exchange coupled multilayers as a free layer for memory storage and bit- and word-line structure with magnetic yoke.

### Summary of the Invention

It is desirable to provide a low power MRAM.

It is also desirable to provide a magnetic yoke structure for use in an MRAM.

According to a first aspect of the present invention there is provided an MRAM device comprising: a substrate; plural conductive lines, including a bit line and a word line; a MTJ stack; and a pair of magnetic yoke structures proximate the MTJ stack, wherein each of said yoke structures has a horse shoe configuration and surrounds one of said conductive lines wherein at least one of said yoke structures includes, *seriatim,* an oxide layer, a NiFe layer, and an oxide layer surrounding the associated conductive line, characterized in that, at said NiFe layer of said yoke structure is formed of three discrete segments of magnetic material NiFe arranged in said horse shoe configuration.

According to a second aspect of the present invention there is provided a method of fabricating a magnetic yoke structure in an MRAM structure, comprising the steps of:
a) preparing a substrate;
b) forming a first conductive line on the substrate;
c) fabricating a first magnetic yoke structure about the first conductive line;
d) fabricating a MTJ stack;
e) forming a second conductive line on the MTJ stack;
f) fabricating a second magnetic yoke structure about the second conductive line;
g) depositing a layer of oxide on the structure; and
h) metallizing the structure obtained by steps a) - g), wherein said step of c) and step of f) fabricating a first and second magnetic yoke structure includes, *seriatim,* depositing an oxide layer, depositing a NiFe layer, and depositing an oxide layer surrounding an associated conductive line
characterised in that, said NiFe layer of at least one of said yoke structures is formed by three discrete segments of magnetic material NiFe arranged in a horse shoe configuration.

Preferred features are set out in the dependent claims.

In order that the present invention be more readily understood, specific embodiments thereof will now be described with reference to the accompanying drawings.

### Brief Description of the Drawings

Fig. 1 depicts a MTJ MRAM element and related circuitry.
Figs. 2 and 3 depict the yoke structure for a MTJ MRAM according to the invention.
Figs. 4-13 depict successive steps in the preferred embodiment of the method of the invention.
Fig. 14 depicts an MRAM array.
Figs. 15-21 depict successive steps in an illustration example.

### Brief Description of the Drawings

A magnetic yoke structure is used in the device of the invention, and a method to make the magnetic yoke structure is described. The programming current is then reduced by 1/µr, where µr is the magnetic permeability of the yoke. If the yoke material used is plated or sputtered NiFe, which has a µr of about 1000, a reduction of programming current to the µA range is achieved.

A basic magnetic tunneling junction MRAM element is composed of the following layers; an anti-ferromagnetic (AF) layer, a ferromagnetic (FM) pinned layer, an insulating tunnelling gap layer, and a ferromagnetic free layer, which are formed into a magnetoresistance stack. Additionally, bottom and top conducting wires are provided to facilitate read and write functions.

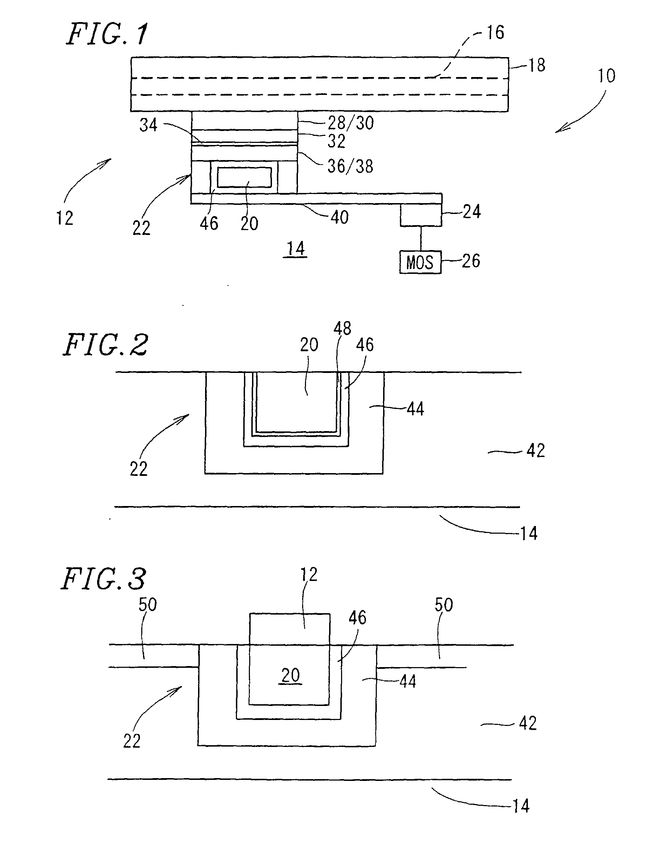

Fig. 1 illustrates a MRAM element 10, and a sandwich structure of a magnetic tunneling junction (MTJ) 12, and the related sensing circuitry, which are located on a substrate 14. As used herein, "substrate" includes a silicon substrate and any layers of conducting, semi-conducting and insulating material fabricated on a silicon substrate. Additionally, the substrate may have MOS transistors fabricated thereon as part of the substrate preparation. The general structure of Fig. 1 includes conducting lines, such as a bit line 16, encapsulated in a horse shoe shaped magnetic yoke structure 18, and a word line 20, also encapsulated in a horse shoe shaped magnetic yoke structure 22, and a via 24, connected to a MOS transistor 26. MTJ 12 includes an AF pinned layer 28, an FM pinned layer 30, an insulating gap layer 32, a tunnel barrier layer 34, FM free layers 36, 38, and a bottom electrode 40. A seed layer and a capping layer are described later herein. Table 1 enumerates a set of parameters for each layer.

**Table 1**

| MTJ Components | |
|---|---|
| Seed Layer | Ta, 7 nm thick |
| Bottom Electrode | NiFe (30 nm); Al (25 nm) + NiFe (4 nm) |
| Exchange Pinning | Antiferromagnetic (AF) Mn₅₄Fe₄₆ (8-10 nm) or IrMn |
| FM Pinned Layer | Co₈₄Fe₁₆ (3 nm); Co₄₀Fe₆₀; Ni₆₀Fe₄₀ or Co (4 nm)/Ru (7 nm)/Co (4 nm) |
| Tunnel Barrier Layer | Al (0.7 ~ 1.0 nm) + plasma oxidation, or ALD Al₂O₃; Critical Layer |
| FM Free Layer | CoFe (3 nm) |
| FM Free Layer | NiFe (7 nm) |
| Capping Layer | Ta (3-10 nm); or Al |

Word line (WL) 20 is surrounded by soft magnetic material of magnetic yoke structure 42, which has a magnetic permeability of about 1000. Calculations indicates that, with the surrounding yoke structure, the programming current may be reduced to the µA range, and generates a 20 Oe programming field in the magnetic free layer, assuming layer thicknesses as given in Table 1. The programming current is about 4 mA, for the same structure, if no magnetic yoke structure is present.

Referring now to Fig. 2, the construction of the first magnetic yoke structure of the invention will be described. A silicon substrate 14 may be either n-type or p-type silicon. A layer of silicon dioxide 42 is deposited onto substrate 14 to a thickness of between about 500 nm to 1000 nm. Oxide layer 42 is etched to form a trench, having a depth of between about 400 nm to 900 nm, depending on the oxide layer thickness, but leaving about 100 nm of oxide on the substrate. A layer 44 of NiFe is deposited by sputtering to a thickness of about 200 nm. Another layer of silicon dioxide 46 is deposited by CVD, followed by deposition of a copper barrier layer 48, which may be TiN or WN, and a conductive line of copper 20 is deposited on copper barrier layer 48. The structure is smoothed by CMP to remove excess copper and to etch copper barrier layer 48. The structure is patterned and partially covered with photoresist to cover conductive line 20. The NiFe layer is removed by an ion milling etching process. The exposed surfaces are covered with silicon dioxide layer 50, after which the structure is smoothed by CMP to expose the conductive line. A MTJ stack 12 is then formed on conductive line 20.

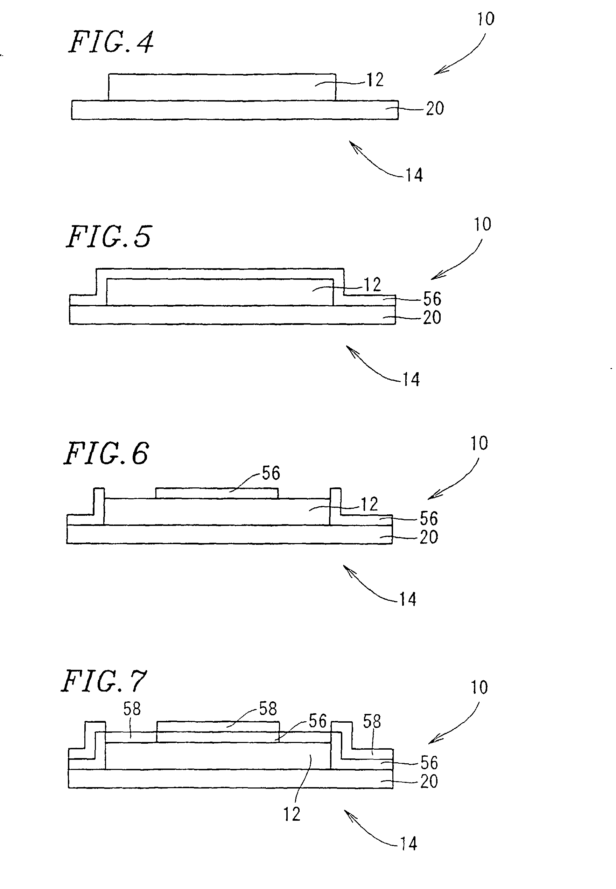

Figs 4-13 depicts successive steps in the fabrication of a magnetic yoke structure for use in an MRAM according to the invention in greater detail. Fig. 4 depicts silicon substrate 14, which may have one or more MOS transistors formed thereon. Word line (WL) 20 is formed as previously described and encapsulated in first magnetic yoke structure 22. WL, referred to herein as a first conductive line, may be formed of a suitable metal, such as aluminum, copper, or platinum, although copper is preferred, to a thickness of between about 400 nm to 900 nm. MTJ stack 12 is fabricated on WL 20 in this embodiment of the invention, and contains the layers of materials listed in Table 1, deposited to the thicknesses listed in Table 1.

Fig. 5, the WL and MTJ stack are covered by a layer of oxide 56. deposited by CVD to a thickness of between about 50 nm to 100 nm.

Fig. 6, the oxide layer is patterned and etched to expose portions of the MTJ stack.

Fig. 7, a layer of NiFe 58 is deposited over the structure to a thickness of about 100 nm. This layer provides a seed layer for subsequent yoke plating.

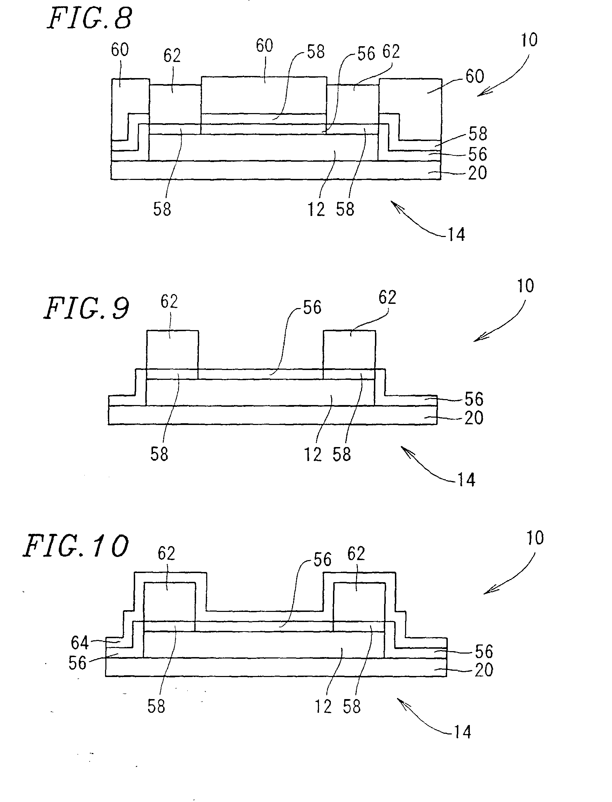

Fig. 8, photoresist 60 is applied and another layer of NiFe 62 is deposited providing for a total NiFe thickness of about 1000 nm.

Fig. 9, the photoresist is stripped and the NiFe is ion milled to remove the NiFe overlaying the oxide, leaving the thicker NiFe layer over those portions of the structure which had the oxide previously removed.

Fig. 10, a layer of oxide 64 is deposited by CVD to a thickness of between about 50 nm to 100 nm, completely covering the structure.

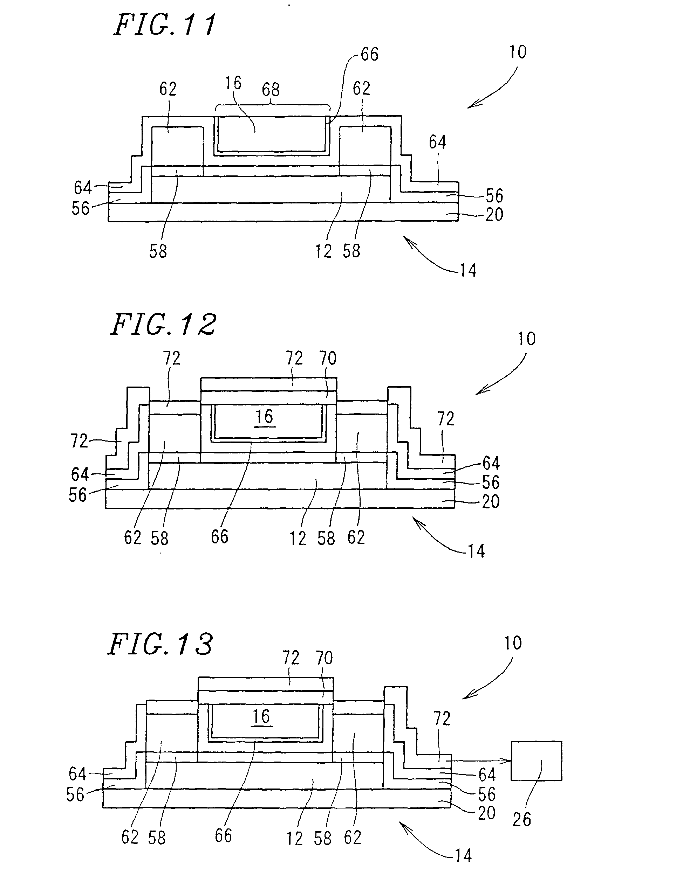

Fig. 11, a metal barrier layer 66 is formed in a bit line trench 68. and the bit line trench is filled with a metal, such as copper, to form bit line (BL) 16, referred to herein as a second conductive line. The structure is polished by chemical mechanical polishing (CMP).

Fig. 12, a layer of oxide 70 is deposited over the structure to a thickness of about 100 nm. The oxide is masked and etched, to open the top of the NiFe layer magnetic contact. Another layer of NiFe 72 is deposited to a thickness of about 200 nm. NiFe elements 62 and 72 form an encapsulating structure 18 for BL 16, which has a horse shoe configuration, as does encapsulating structure 22.

Fig. 13, the structure is patterned, and the NiFe is removed by ion milling on the left side of the figure. The NiFe material on the right side of the figure is connecter to transistor 26. The structure is completed and finished by appropriate metallization. The BL and WL may be interchanged, *i.e*., the BL may be formed as the second conductive line and the WL may be formed as the first conductive line, therefore, the fabrication process for these structures and their magnetic yoke structures may also be interchanged.

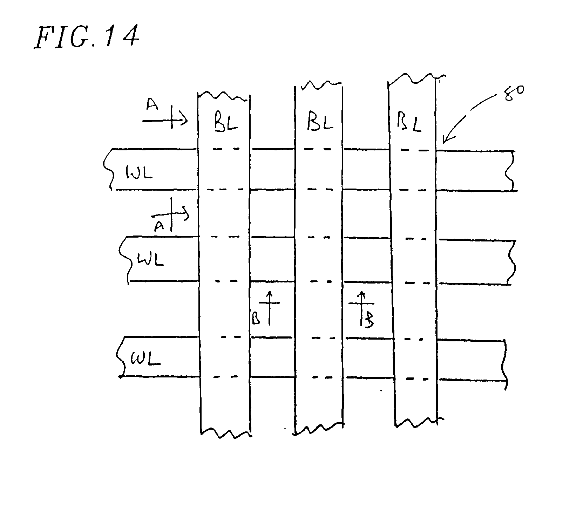

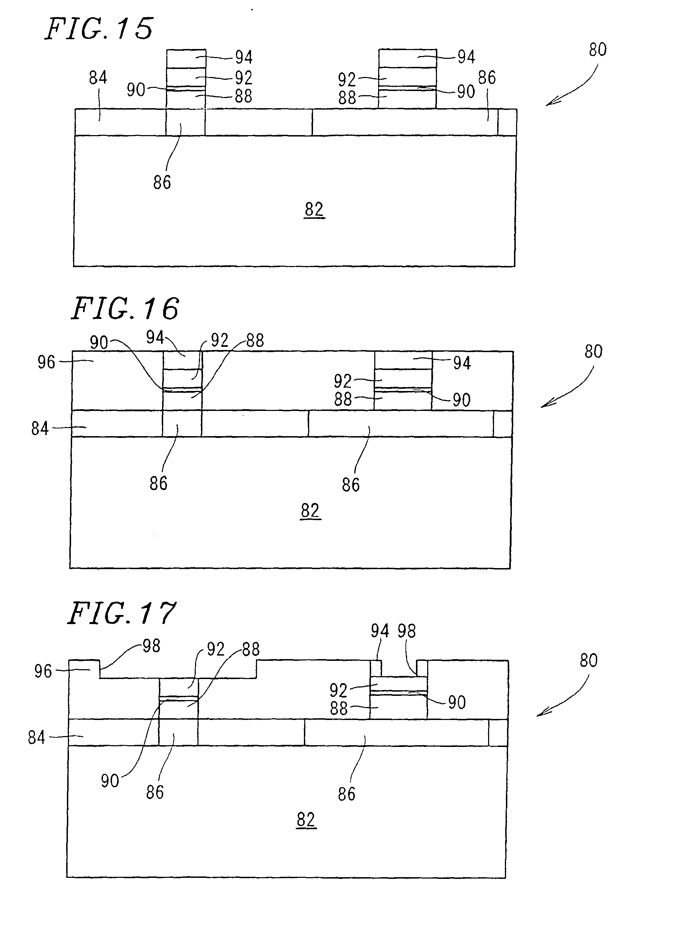

An method of fabricate an MRAM as illustration example is described in conjunction with Figs. 14-21. Turning to Fig. 14, the structure is depicted in a top plan view, showing the orientation of the remaining Figs 15-21. In each of Fig. 15 to 21, the left side of the figure is a cross-section taken parallel to the BL, view A-A, while the right side of the figure is a cross-section taken parallel to the WL, view B-B. Again, the first step in fabricating a magnetic yoke structure 80 is preparing a substrate 82. The substrate may be a silicon wafer of either n-type or p-type, with MOS transistors fabricated thereon. As shown in Fig. 15, an oxide layer 84 is formed on the substrate to a thickness of between about 500 nm to 1000 nm. The oxide layer 84 is patterned and etched by a dual damascene process, and metal for a WL 86 is deposited, as by CVD or PVD. The metal deposited may be aluminum, copper or platinum. A fixed magnetic layer stack 88 of Ta, NiMn, CoFe; Ta, FeMn, CoFe: or Ta, NiFe, FeMn, CoFe is deposited to a thickness of between about 45 nm to 55 nm and a layer 90 of AlₓO_{y} is deposited to a thickness of between about one nm to two nm to form a tunnel barrier layer. A free magnetic layer 92 of NiFe is then deposited to a thickness of between about seven nm to twelve nm, followed by a layer of silicon nitride 94, which is deposited to a thickness of between about 500 nm to 1000 nm. The structure is patterned and etched, resulting in the memory stack structure of Fig. 15.

A layer of oxide 96 is deposited to a thickness of between about 800 nm and 1400 nm. The structure is smoothed by CMP, resulting in the structure of Fig. 16. The structure is covered with photoresist and appropriate vias and trenches are formed to a depth of between about 500 nm and 1000 nm, by a dual damascene process to form BL trenches 98. Oxide layer 96 is then etched, as is silicon nitride layer 94, resulting in the structure of Fig. 17.

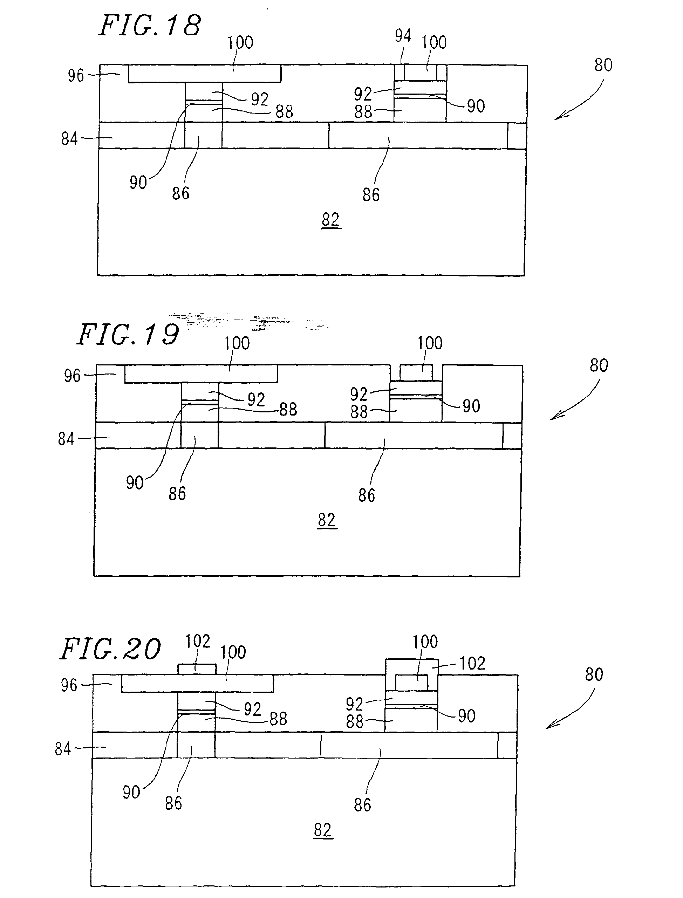

Turning to Fig. 18, copper is deposited by CVD into the BL trenches, forming BL 100, and finished by CMP. Silicon nitride layer 94 is removed by a wet etch process, resulting in the structure of Fig. 19. A second free magnetic layer 102 is deposited to a thickness of between about 500 nm to 1000 nm, overlying the BL, and filling the trenches left by the nitride removal. Portions of the second free magnetic layer are covered with photoresist, and the remainder is removed by etching, leaving the structure ofFig. 20.

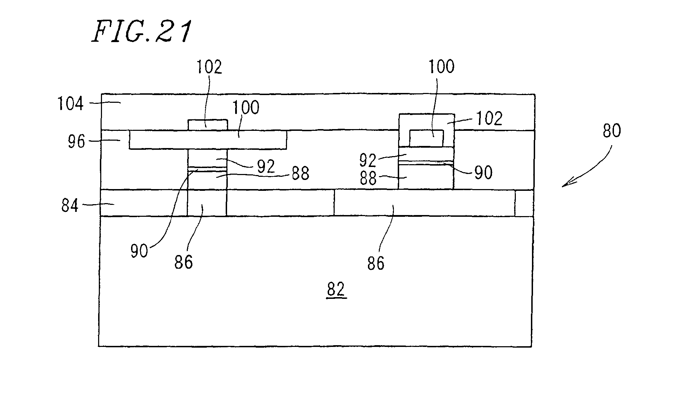

Referring to Fig 21, a layer of oxide 104 is deposited to a thickness of between about 1000 nm and 2000 nm, passivated, and the structure metallized (not shown), completing a magnetic yoke structure. The structure may be inverted, *i.e.*, the BL may be on the bottom of the MR stack and the WL may be on the top of the stack.

Thus, a magnetic yoke structure has been disclosed in figures 1 and 4-13 which may be used in MRAM devices to reduce programming power consumption, as has a method of making the magnetic yoke structure of the invention. It will be appreciated that further variations and modifications thereof may be made within the scope of the invention as defined in the appended claims.

## Claims

1. An MRAM device (10) comprising:
a substrate (14);
plural conductive lines, including a bit line (16) and a word line (20);
a MTJ stack (12); and
a pair of magnetic yoke structures (18,22) proximate the MTJ stack (12), wherein each of said yoke structures (18,22) has a horse shoe configuration and surrounds one of said conductive lines (16,20), wherein at least one of said yoke structures (18, 22) includes, *seriatim*, an oxide layer (70), a NiFe layer (72), and an oxide layer surrounding the associated conductive line **characterized in that**,
said NiFe layer of said yoke structure (18) is formed of three discrete segments (62,72) of magnetic material NiFe arranged in said horse shoe configuration.

2. The MRAM device of claim 1 wherein said substrate (14) includes a MOS transistor (26) connected to one of said plural conductive lines.

3. The MRAM device of claim 1 wherein said MTJ stack (12) includes an AF pinned layer (28), an FM pinned layer (30), an insulating gap (32), a tunnel barrier layer, two FM free layers (36,38), bottom electrode (40), a seed layer and a capping layer.

4. The MRAM device of claim 1 wherein said yoke structure (18,22) includes a copper barrier layer located between said NiFe layer and said conductive line, and wherein said copper barrier layer is taken from the group of material consisting of TiN and WN.

5. The MRAM device of claim 1 wherein said substrate includes a MOS transistor (26), and wherein a first conductive line is formed on the substrate (14) and is surrounded by an encapsulating magnetic yoke structure; and wherein said MTJ stack (12) includes a fixed magnetic layer (88) taken from the group of magnetic layers consisting of Ta, NiMn, CoFe; Ta, FeMn, CoFe; and Ta, NiFe, FeMn, CoFe; wherein said MTJ stack further includes a tunnel barrier layer (90) and a free magnetic layer (92).

6. The MRAM device of claim 5 wherein said free magnetic layer (92) is taken from the group of magnetic layers consisting of NiFe and CoFe.

7. A method of fabricating a magnetic yoke structure (18, 22) in an MRAM structure (10), comprising the steps of:
a) preparing a substrate (14);
b) forming a first conductive line on the substrate (14);
c) fabricating a first magnetic yoke structure about the first conductive line;
d) fabricating a MTJ stack (12);
e) forming a second conductive line on the MTJ stack (12);
f) fabricating a second magnetic yoke structure about the second conductive line;
g) depositing a layer of oxide on the structure; and
h) metallizing the structure obtained by steps a) - g), wherein said step of c) and step of f) fabricating a first and second magnetic yoke structure includes, *seriatim,* depositing an oxide layer (70), depositing a NiFe layer (72), and depositing an oxide layer surrounding an associated conductive line **characterised in that**,
said NiFe layer of at least one of said yoke structures (18,22) is formed by three discrete segments (62, 72) of magnetic material NiFe arranged in a horse shoe configuration.

8. The method of claim 7 wherein said step of b) forming a first conductive line on the substrate (14) includes forming a bit line on the substrate (14), and wherein said step of d) forming a second conductive line on the MTJ stack (12) includes forming a word line on the MTJ stack (12).

9. The method of claim 7 wherein said step of b) forming a first conductive line on the substrate (12) includes forming a word line on the substrate, and wherein said step of d) forming a second conductive line on the MTJ stack includes forming a bit line on the MTJ stack (12).

10. The method of claim 7 wherein said step of a) preparing the substrate includes fabricating a MOS transistor (26) on the substrate (14); and which further includes connecting the MOS transistor (26), to one of the pair of magnetic yoke structures (18, 22).

11. The method of claim 7 wherein said step of c) fabricating a first magnetic yoke structure and said step of e) fabricating a second magnetic yoke structure includes fabricating horseshoe shaped structures.

12. The method of claim 7 wherein said step of c) and step of e) fabricating a first and second magnetic yoke structure includes fabricating a copper barrier layer located between the NiFe layer and the associated conductive line, and wherein the copper barrier layer is taken from the group of material consisting of TiN and WN.

13. The method of claim 7 wherein said step of a) preparing a substrate includes fabricating MOS transistor (26) on the substrate (12), and wherein said step of b) fabricating a MTJ stack includes fabricating a fixed magnetic layer taken from the group of magnetic layers consisting of Ta, NiMn, CoFe; Ta, FeMn, CoFe; and Ta, NiFe, FeMn, CoFe; and which further includes fabricating a tunnel barrier layer and fabricating a free magnetic layer.

14. The method of claim 13, wherein said fabricating a free magnetic layer includes fabricating a layer taken from the group of magnetic layers consisting of NiFe and CoFe.

## Patentansprüche

1. MRAM (10) mit:
einem Substrat (14);
mehreren Leitungen, einschließlich einer Bitleitung (16) und einer Wortleitung (20);
einem MTJ-Stapel (12) und
einem Paar von Magnetjochstrukturen (18, 22) benachbart zum MTJ-Stapel (12), von denen jede über Hufeisenkonfiguration verfügt und eine der Leitungen (16, 20) umgibt, wobei mindestens eine der Jochstrukturen (18, 22) der Reihe nach über eine Oxidschicht (70), eine NiFe-Schicht (72) und eine Oxidschicht um die zugehörige Leitung herum verfügt;
**dadurch gekennzeichnet, dass** die NiFe-Schicht der Jochstruktur (18) aus drei diskreten Segmenten (62, 72) des magnetischen Materials NiFe, die mit der Hufeisenkonfiguration angeordnet sind, besteht.

2. MRAM nach Anspruch 1, bei dem das Substrat (14) über einen MOS-Transistor (26) verfügt, der mit einer der mehreren Leitungen verbunden ist.

3. MRAM nach Anspruch 1, bei dem der MTJ-Stapel (12) über eine AF-Pinningschicht (28), eine FM-Pinningschicht (30), einen Isolierspalt (32), eine Tunnelbarriereschicht, zwei FM-freie Schichten (36, 38), eine untere Elektrode (40), eine Keimbildungsschicht und eine Deckschicht verfügt.

4. MRAM nach Anspruch 1, bei dem die Jochstruktur (18, 22) über eine zwischen der NiFe-Schicht und der Leitung liegende Kupferbarriereschicht verfügt, die aus der aus TiN und WN bestehenden Materialgruppe entnommen ist.

5. MRAM nach Anspruch 1, bei dem das Substrat (14) über einen MOS-Transistor (26) verfügt und auf ihm eine erste Leitung ausgebildet ist, mit einer einschließenden Magnetjochstruktur darum herum, und bei dem der MTJ-Stapel (12) über eine Schicht (88) mit fester Magnetisierung verfügt, die aus der Gruppe von Magnetschichten entnommen ist, die aus Ta, NiMn, CoFe; Ta, FeMn, CoFe; und Ta, NiFe, FeMn, CoFe bestehen; wobei der MTJ-Stapel ferner über eine Tunnelbarriereschicht (90) und eine Schicht (92) mit freier Magnetisierung verfügt.

6. MRAM nach Anspruch 5, bei dem die Schicht (92) mit freier Magnetisierung aus der Gruppe von Magnetschichten entnommen ist, die aus NiFe und CoFe bestehen.

7. Verfahren zum Herstellen einer Magnetjochstruktur (18, 22) in einer MRAM-Struktur (10), mit den folgenden Schritten:
a) Bereitstellen eines Substrats (14);
b) Herstellen einer ersten Leitung auf dem Substrat (14);
c) Herstellen einer ersten Magnetjochstruktur um die erste Leitung herum;
d) Herstellen eines MTJ-Stapels (12);
e) Herstellen einer zweiten Leitung auf dem MTJ-Stapel (12);
f) Herstellen einer zweiten Magnetjochstruktur um die zweite Leitung herum;
g) Abscheiden einer Oxidschicht auf der Struktur; und
h) Metallisieren der durch die Schritte a) - g) erhaltenen Struktur, wobei es zum Schritt c) und zum Schritt f) des Herstellens einer ersten und zweiten Magnetjochstruktur gehört, der Reihe nach eine Oxidschicht (70), eine NiFe-Schicht (72) und eine Oxidschicht um eine zugehörige Leitung herum abzuscheiden;
**dadurch gekennzeichnet, dass** die NiFe-Schicht mindestens einer der Jochstrukturen (18, 22) durch drei diskrete Segmente (62, 72) des magnetischen Materials NiFe hergestellt wird, die mit einer Hufeisenkonfiguration angeordnet werden.

8. Verfahren nach Anspruch 7, bei dem es zum Schritt b) des Herstellens einer ersten Leitung auf dem Substrat (14) gehört, eine Bitleitung auf dem Substrat (14) herzustellen, und wobei es zum Schritt d) des Herstellens einer zweiten Leitung auf dem MTJ-Stapel (12) gehört, eine Wortleitung auf diesem herzustellen.

9. Verfahren nach Anspruch 7, bei dem es zum Schritt b) des Herstellens einer ersten Leitung auf dem Substrat (14) gehört, eine Wortleitung auf dem Substrat herzustellen, und es zum Schritt d) des Herstellens einer zweiten Leitung auf dem MTJ-Stapel (12) gehört, eine Bitleitung auf diesem herzustellen.

10. Verfahren nach Anspruch 7, bei dem es zum Schritt a) des Bereitstellens des Substrats (14) gehört, einen MOS-Transistor (26) auf diesem herzustellen; und zu dem es ferner gehört, den MOS-Transistor (26) mit einer Struktur des Paars von Magnetjochstrukturen (18, 22) zu verbinden.

11. Verfahren nach Anspruch 7, bei dem es zum Schritt c) des Herstellens einer ersten Magnetjochstruktur und zum Schritt e) des Herstellens einer zweiten Magnetjochstruktur gehört, hufeisenförmige Strukturen herzustellen.

12. Verfahren nach Anspruch 7, bei dem es zum Schritt c) und zum Schritt d) des Herstellens einer ersten und zweiten Magnetjochstruktur gehört, eine zwischen der NiFe-Schicht und der zugehörigen Leitung liegende Kupferbarriereschicht herzustellen, und bei dem diese aus der aus TiN und WN bestehenden Materialgruppe entnommen wird.

13. Verfahren nach Anspruch 7, bei dem es zum Schritt a) des Bereitstellens eines Substrats (12) gehört, einen MOS-Transistor (26) auf diesem herzustellen, und es zum Schritt b) des Herstellens eines MTJ-Stapels gehört, eine Schicht mit fester Magnetisierung herzustellen, die aus der Gruppe von Magnetschichten entnommen wird, die aus Ta, NiMn, CoFe; Ta, FeMn, CoFe; und Ta, NiFe, FeMn, CoFe bestehen; und zu dem ferner das Herstellen einer Tunnelbarriereschicht und das Herstellen einer Schicht mit freier Magnetisierung gehören.

14. Verfahren nach Anspruch 13, bei dem es zum Herstellen einer Schicht mit freier Magnetisierung gehört, eine Schicht herzustellen, die aus der Gruppe von aus NiFe und CoFe bestehenden magnetischen Schichten entnommen wird.

## Revendications

1. Dispositif formant MRAM (10), comprenant :
un substrat (14) ;
plusieurs lignes conductrices, y compris une ligne de bits (16) et une ligne de mots (20) ;
une pile MTJ (12) ; et
une paire de structures de culasse magnétique (18, 22) à proximité de la pile MTJ (12),
dans lequel chacune desdites structures de culasse (18, 22) présente une configuration de fer à cheval et entoure une desdites lignes conductrices (16, 20), dans lequel au moins une desdites structures de culasse (18, 22) comprend, en série, une couche d'oxyde (70), une couche de NiFe (72) et une couche d'oxyde entourant la ligne conductrice associée, **caractérisé en ce que**
ladite couche de NiFe de ladite structure de culasse (18) est formée de trois segments distincts (62, 72) de matériau magnétique de NiFe agencés dans ladite configuration de fer à cheval.

2. Dispositif formant MRAM selon la revendication 1, dans lequel ledit substrat (14) comprend un transistor MOS (26) connecté à une desdites plusieurs lignes conductrices.

3. Dispositif formant MRAM selon la revendication 1, dans lequel ladite pile MTJ (12) comporte une couche à broche AF (28), une couche à broche FM (30), un espace isolant (32), une couche barrière à effet tunnel, deux couches sans FM (36, 38), une électrode inférieure (40), une couche d'ensemencement et une couche de recouvrement.

4. Dispositif formant MRAM selon la revendication 1, dans lequel ladite structure de culasse (18, 22) comporte une couche barrière en cuivre située entre ladite couche de NiFe et ladite ligne conductrice, et dans lequel ladite couche barrière en cuivre est choisie dans le groupe de matériaux constitué de TiN et WN.

5. Dispositif formant MRAM selon la revendication 1, dans lequel ledit substrat comprend un transistor MOS (26), et dans lequel une première ligne conductrice est formée sur le substrat (14) et est entourée par une structure de culasse magnétique d'encapsulage ; et dans lequel ladite pile MTJ (12) comprend une couche magnétique fixe (88) choisie dans le groupe de couches magnétiques constitué de Ta, NiMn, CoFe, Te ; Ta, FeMn, CoFe ; et Ta, NiFe, FeMn, CoFe ; dans lequel ladite pile MTJ comprend en outre une couche barrière à effet tunnel (90) et une couche non magnétique (92).

6. Dispositif formant MRAM selon la revendication 5, dans lequel ladite couche non magnétique (92) est choisie dans le groupe de couches magnétiques constitué de NiFe et CoFe.

7. Procédé de fabrication d'une structure de culasse magnétique (18, 22) dans une structure de MRAM (10), comprenant les étapes consistant à :
a) préparer un substrat (14) ;
b) former une première ligne conductrice sur le substrat (14) ;
c) fabriquer une première structure de culasse magnétique autour de la première ligne conductrice ;
d) fabriquer une pile MTJ (12) ;
e) former une seconde ligne conductrice sur la pile MTJ (12) ;
f) fabriquer une seconde structure de culasse magnétique autour de la seconde ligne magnétique ;
g) déposer une couche d'oxyde sur la structure ; et
h) métalliser la structure obtenue par les étapes a) à g), dans lequel lesdites étapes c) et f) de fabrication de première et seconde structures de culasse magnétique comprennent, en série, le dépôt d'une couche d'oxyde (70), le dépôt d'une couche de NiFe (72) et le dépôt d'une couche d'oxyde entourant une ligne conductrice associée, **caractérisé en ce que**,
ladite couche de NiFe d'au moins une desdites structures de culasse (18, 22) est formée par trois segments distincts (62, 72) de matériau magnétique de NiFe agencés selon une configuration de fer à cheval.

8. Procédé selon la revendication 7, dans lequel ladite étape b) de formation d'une première ligne conductrice sur le substrat (14) comprend la formation d'une ligne de bits sur le substrat (14), et dans lequel ladite étape d) de formation d'une seconde ligne conductrice sur la pile MTJ (12) comprend la formation d'une ligne de mots sur la pile MTJ (12).

9. Procédé selon la revendication 7, dans lequel ladite étape b) de formation d'une première ligne conductrice sur le substrat (14) comprend la formation d'une ligne de mots sur le substrat, et dans lequel ladite étape d) de formation d'une seconde ligne conductrice sur la pile MTJ comporte la formation d'une ligne de bits sur la pile MTJ (12).

10. Procédé selon la revendication 7, dans lequel ladite étape a) de préparation du substrat comprend la fabrication d'un transistor MOS (26) sur le substrat (14) ; et qui comprend en outre la connexion du transistor MOS (26) à une de la paire de structures de culasse magnétique (18, 22).

11. Procédé selon la revendication 7, dans lequel ladite étape c) de fabrication d'une première structure de culasse magnétique et ladite étape e) de fabrication d'une seconde structure de culasse magnétique comprennent la fabrication de structure en forme de fer à cheval.

12. Procédé selon la revendication 7, dans lequel ladite étape c) et ladite étape e) de fabrication de première et seconde structures de culasse magnétique comprennent la fabrication d'une couche barrière en cuivre située entre la couche de NiFe et la ligne conductrice associée, et dans lequel la couche barrière en cuivre est prise dans le groupe de matériaux constitué de TiN et WN.

13. Procédé selon la revendication 7, dans lequel ladite étape a) de préparation d'un substrat comprend la fabrication d'un transistor MOS (26) sur le substrat (14), et dans lequel ladite étape b) de fabrication d'une pile MTJ comprend la fabrication d'une couche magnétique fixe choisie dans le groupe de couches magnétiques constitué de Ta, NiMn, CoFe ; Ta, FeMn, CoFe ; et Ta, NiFe, FeMn, CoFe ; et qui comprend en outre la fabrication d'une couche barrière à effet tunnel et la fabrication d'une couche non magnétique.

14. Procédé selon la revendication 13, dans lequel ladite fabrication d'une couche non magnétique comprend la fabrication d'une couche choisie dans le groupe de couches magnétiques constitué de NiFe et CoFe.
